# FASCICULE DE BREVET EUROPEEN

(11) **EP 1 025 584 B1**
(45) Date de publication et mention de la délivrance du brevet: **10.06.2009**
(21) Numéro de dépôt: 99939494.3
(22) Date de dépôt: 24.08.1999
(51) Int. Cl.: H01L 23/14, H01L 21/784, H01L 21/56

(54) **CIRCUIT ELECTRONIQUE INTEGRE COMPRENANT AU MOINS UN COMPOSANT ELECTRONIQUE DE PUISSANCE**
ELEKTRONISCHE INTEGRIERTE SCHALTUNG MIT MINDESTENS EINEM ELEKTRONISCHEN BAUELEMENT
INTEGRATED ELECTRONIC CIRCUIT COMPRISING AT LEAST AN ELECTRONIC POWER COMPONENT

(30) Priorité: 25.08.1998 FR 9810688
(43) Date de publication de la demande: 09.08.2000
(73) Titulaire: COMMISSARIAT A L'ENERGIE ATOMIQUE, 75015 Paris (FR)
(72) Inventeur: GIDON, Pierre, F-38130 Echirolles (FR)
(74) Mandataire: Weber, Etienne Nicolas
(86) Numéro de dépôt international: PCT/FR1999/002033
(87) Numéro de publication internationale: WO 2000/011713

(56) Documents cités:
- EP-A- 0 662 721
- WO-A-95/19645
- FR-A- 2 012 333
- GB-A- 1 467 354

## Description

### Domaine technique

La présente invention concerne un circuit électronique et un procédé de réalisation d'un circuit électronique intégré comprenant au moins un composant électronique, en particulier un composant électronique de puissance, dans une plaque de substrat.

Au sens de la présente invention, on entend par composant électronique aussi bien un composant individuel tel qu'une diode, ou un transistor, qu'un ensemble fonctionnel de composants tel qu'un étage d'amplification ou une unité de commutation logique.

Par ailleurs, on entend par composant de puissance un composant susceptible d'être traversé par des courants importants ou de recevoir à ses bornes des tensions élevées. De tels composants sont, par exemple, des diodes, des transistors, des thyristors, susceptibles de fonctionner sous des tensions qui peuvent atteindre, selon les applications, plusieurs milliers de volts, et/ou susceptibles d'être traversés par des courants de plusieurs dizaines d'ampères.

L'invention trouve des applications dans la fabrication de circuits de pilotage de moteurs électriques, de circuits de protection, tels que des circuits disjoncteurs, limiteurs ou régulateurs de puissance, ou encore dans des circuits combinants des étages de commutation logique et des étages de commutation de puissance.

### Etat de la technique antérieure

Les circuits intégrés de pilotage de moteurs ou les circuits de régulation de puissance comportent généralement un ou plusieurs composants de puissance, pouvant occuper une place importante sur un substrat d'intégration, jusqu'à plusieurs mm² par composant. Il comportent également des composants électroniques de commande associés aux composants de puissance, les composants de commande fonctionnant sous faible tension et avec un faible courant.

Des impératifs de coût de fabrication et d'encombrement conduisent à réunir les composants de puissance et les autres composants du circuit en une seule unité monolithique susceptible d'être fabriqués selon des techniques de traitement collectif.

La fabrication d'unités monolithiques intégrant tous les composants d'un circuit, comprend généralement l'intégration des composants de puissance et les autres composants dans une même plaque de substrat.

Cette intégration, pose alors des problèmes d'isolation électrique qui imposent soit une modification des composants eux-mêmes, en privilégiant des techniques de fabrication des composants en surface, au détriment d'une fabrication dans l'épaisseur de la plaque de substrat, soit imposent des préparations complexes des substrats avant la réalisation des composants.

Ces préparations d'isolation électrique peuvent comporter la diffusion d'impuretés dopantes, à haute température, dans la plaque de substrat afin de former des barrières de jonction. Selon d'autres techniques, l'isolation peut être obtenue par une réalisation de parois diélectriques (caissons) dans le substrat avant d'y intégrer les composants.

La modification des composants eux-mêmes ou les préparations du substrat sont des opérations complexes et coûteuses qui sont généralement peu compatible avec les exigences de rendement de fabrication et d'intégration à forte densité des composants.

Le document GB 1 467 354 A décrit un circuit intégré comprenant une pluralité de composants et un procédé de réalisation d'un tel circuit intégré.

### Exposé de l'invention

La présente invention a pour but de proposer un procédé de fabrication d'un circuit électronique intégré pouvant comporter à la fois des composants électroniques de puissance et d'autres composants électroniques, et ne présentant pas les difficultés mentionnées ci-dessus.

Un but est en particulier de proposer un tel procédé qui n'impose aucune contrainte de fabrication ou de modification des composants eux-mêmes en vue de leur isolation électrique mutuelle.

Un but est aussi de proposer un procédé permettant d'intégrer tous les composants dans un même substrat sans préparation particulière du substrat.

Un but est encore de proposer un procédé permettant d'isoler avec une efficacité améliorée des composants fonctionnant sous haute tension et des composants fonctionnant sous basse tension.

Un autre but est de proposer un procédé permettant de réaliser des unités monolithiques comprenant tous les composants d'un circuit électronique, et dont les faces extérieures sont sensiblement exemptes de bornes de connexion. L'absence de bornes de connexion sur les faces extérieures offre la possibilité d'équiper les unités de radiateurs de dissipation thermique.

Encore un autre but de l'invention est de proposer un tel procédé permettant une fabrication collective et simultanée d'un grand nombre de circuits électroniques identiques.

Pour atteindre ces buts, la présente invention a plus précisément pour objet un procédé de réalisation d'un circuit intégré selon la revendication 1, le circuit intégré comprenant une pluralité de composants électriques dont, par exemple, un ou plusieurs composant(s) de puissance. Le procédé comporte les étapes successives suivantes :
a) formation de la pluralité de composants dans une plaque de substrat, et formation de plots de connexion pour lesdits composants, sur une première face de la plaque de substrat,
b) formation, sur un support de connexion, de pistes conductrices selon un motif en correspondance avec une distribution des plots de connexion sur la plaque de substrat,
c) report de la plaque de substrat sur le support de connexion en connectant électriquement les plots de connexion avec des pistes conductrices correspondantes,
d) formation d'au moins une tranchée de séparation dans la plaque de substrat, entourant au moins une portion de substrat comprenant au moins un composant électronique, de façon à le séparer des autres composants électroniques de la plaque de substrat, la tranchée de séparation traversant la plaque de substrat de part en part sans atteindre le support de connexion,
e) emplissage des tranchées d'un matériau diélectrique.

La formation des tranchées de séparation, combinée à leur remplissage avec un matériau diélectrique permet d'isoler efficacement les unes des autres plusieurs portions de substrat comprenant chacune un ou plusieurs composants électroniques. Il est possible en particulier d'isoler mutuellement des portions de substrat comprenant des composants de puissance, en particulier de haute tension, et des portions de substrat comprenant des composants fonctionnant en basse tension.

Cette particularité de l'invention permet de réaliser initialement tous les composants dans la même plaque de substrat sans se soucier de leur isolation électrique. Ainsi, les procédés de fabrication des composants peuvent être choisis librement ou en fonction d'impératifs autres que l'isolation électrique, et la plaque de substrat ne requiert pas de préparation particulière.

De plus, comme la formation des tranchées est postérieure au report de la plaque de substrat sur le support de connexion, la connexion de tous les composants peut avoir lieu de façon collective et simultanée.

Cette particularité est avantageuse notamment dans le cadre d'une fabrication industrielle des circuits intégrés.

Selon une mise en oeuvre particulière du procédé, on peut pratiquer dans la plaque de substrat, avant l'étape c), des rainures d'évasement des tranchées en des emplacements destinés à la formation des tranchées lors de l'étape d).

Le fait d'évaser les extrémités des tranchées permet d'éviter que les bords des portions de plaque de substrat de part et d'autre des tranchées ne forment des arêtes vives et ne concentrent un champ électrique existant entre les portions de plaque de substrat. Ainsi, la tenue en tension entre les différentes portions peut être augmentée.

Les rainures d'évasement peuvent être réalisées avec des bords chanfreinés, au moyen d'une lame de scie à bord oblique. Elles peuvent également être réalisées par gravure en conférant aux bords une forme arrondie.

Lors de l'étape c) du procédé, on peut connecter les plots et les pistes conductrices par un procédé de connexion choisi, par exemple, parmi la connexion par bossages de matériau fusible, la connexion par colle conductrice, ou la connexion par soudure eutectique.

Une connexion par bossage et en particulier par billes de matériau fusible est préférée notamment lorsque le nombre de plots de connexion des composants est élevé. De plus, la technique de connexion par billes de matériau fusible, encore connue sous la désignation de "Flip chip", permet un report de la plaque de substrat sur le support de connexion avec des tolérances d'alignement plus grandes. En effet, un positionnement mutuel précis entre la plaque de substrat et le support est automatiquement obtenu sous l'effet de forces de tension superficielles qui s'exercent dans le matériau des billes, lorsqu'il est fondu.

Lorsqu'une connexion par bossages de matériau fusible est retenue, il est possible, lors de l'étape e) du procédé de faire pénétrer le matériau diélectrique, introduit par les tranchées, entre la plaque de substrat et le support de connexion, afin d'en enrober lesdits bossages.

La mise en place du matériau diélectrique dans tout l'espace libre entre la plaque de substrat et le support de connexion permet de contrôler précisément l'isolation électrique entre les composants mais aussi entre les bossages de matériau fusible, utilisés comme voie de connexion électrique.

Après la mise en place du matériau diélectrique, le procédé peut être complété par la formation de plots de contact et de pistes de d'interconnexion sur une deuxième face, libre, de la plaque de substrat, opposée à ladite première face.

Une telle interconnexion des composants, par la "face arrière", est en particulier suggérée pour les composants de puissance.

De préférence, pour réaliser les connexions sur la deuxième face de la plaque de substrat, il est souhaitable que cette face présente une surface plane. Aussi, le matériau diélectrique mis en place dans les tranchées, l'est de préférence de telle manière que ce matériau affleure juste à la surface de la deuxième plaque.

Selon un autre aspect avantageux de l'invention, le procédé peut comporter, en outre, la mise à nu d'une partie du support de connexion, dans laquelle s'étend au moins une piste conductrice reliée à au moins l'un des composants.

Cette caractéristique permet d'accéder aux pistes conductrices en vue de réaliser des connexions vers l'extérieur, et donc de limiter ou de supprimer les prises de connexion sur les faces extérieures libres de la plaque de substrat ou du support.

Ces faces peuvent alors être mises en contact avec des radiateurs pour la dissipation de la chaleur produite par les composants de puissance.

L'invention concerne également un circuit intégré comprenant une pluralité de composants, formés dans des portions d'un substrat séparées par des tranchées, une plaque de support des portions de substrat, équipée de pistes conductrices connectées aux composants, et un matériau diélectrique s'étendant dans lesdites tranchées et, au moins en partie, entre les portions de substrat et la plaque de support. Un tel circuit peut être obtenu par le procédé décrit ci-dessus.

Il peut comporter des composants de puissance et des composants de commutation logique formés dans des portions de substrat différentes.

D'autres caractéristiques et avantages de la présente invention ressortiront mieux de la description qui va suivre, en référence aux figures des dessins annexés. Cette description est donnée à titre purement illustratif et non limitatif.

### Brève description des figures

- Les figures 1 à 3 sont des coupes schématiques simplifiées d'une plaque de substrat et montrent des étapes de préparation de la plaque selon une mise en oeuvre particulière du procédé de l'invention.
- La figure 4 est une coupe schématique simplifiée d'un support de connexion destiné à être utilisé pour la mise en oeuvre du procédé.
- La figure 5 est une coupe schématique simplifiée de la plaque de substrat et du support de connexion illustrant l'assemblage de ces parties.
- La figure 6 est une coupe schématique de la structure de la figure 5, illustrant une étape de formation de tranchées dans la plaque de substrat.
- La figure 7 est une coupe schématique de la plaque de substrat et du support de connexion illustrant la mise en place d'un matériau diélectrique dans les tranchées.
- La figure 8 est une coupe schématique d'une structure conforme à celle de la figure 7 illustrant la réalisation de pistes d'interconnexion sur la face "arrière" de la plaque de substrat.
- La figure 9 est une coupe schématique de la structure de la figure 8 et illustre une opération de découpage de la plaque de substrat et du support de connexion.
- La figure 10 est une coupe schématique d'une structure semblable à celle de la figure 9, obtenue selon une autre possibilité de mise en oeuvre du procédé de l'invention.

### Description détaillée de modes de mise en oeuvre de l'invention

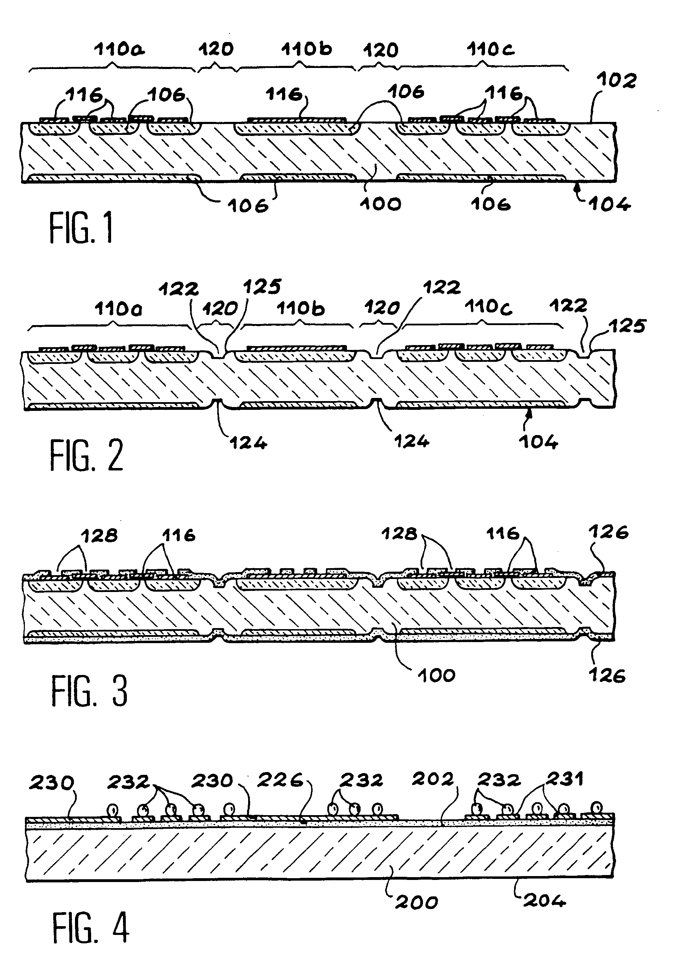

La figure 1 montre en coupe une partie de plaque de substrat 100, par exemple en silicium, présentant une première face 102 dite "face avant" et une deuxième face 104 dite "face arrière".

Des régions dopées 106 formées dans la plaque de substrat à partir de la face avant et de la face arrière permettent de définir dans la plaque de substrat différents composants, ou parties de composant.

Dans l'exemple de la figure, la partie de plaque de substrat représentée comporte trois composants 110a, 110b, 110c qui sont, par exemple, un transistor bipolaire à grille isolée (IGBT), une diode et un deuxième transistor bipolaire à grille isolée.

La référence 116 de la figure 1 désigne de façon indifférente des plots de connexion formés sur la face avant de la plaque de substrat 100. Les plots de connexion peuvent être des plots constituant des prises de contact sur les régions dopées affleurant à la face avant du substrat ou peuvent être des grilles de commande isolées de la face avant par une mince couche d'oxyde de grille, par exemple. Les plots de connexion sont réalisés de préférence en un métal tel que l'aluminium ou un alliage tel que AlSiCu ou un empilement de couches métalliques par exemple titane, nickel, or.

On observe sur la figure 1 que les régions dopées 106 sont formées selon un agencement tel que les composants 110a, 110b, 110c ne soient pas jointifs mais soient séparés par des plages 120, appelées plages de séparation dans la suite du texte.

La figure 2 illustre la formation dans les plages de séparation de rainures 122 s'étendant respectivement autour des composants 110a, 110b, 110c. Les rainures présentent des bords dont les arêtes sont rabattues par un chanfrein ou par un arrondi 125. Les rainures sont destinées à évaser l'extrémité de tranchées pratiquées ultérieurement dans la plaque de substrat 100. Des rainures équivalentes 124 sont également pratiquées dans la face arrière 104, de façon à coïncider avec les rainures 122 de la face avant.

Il convient de préciser que, dans d'autres possibilités de mise en oeuvre du procédé, l'étape de formation de certaines rainures d'évasement et l'étape de formation des tranchées, décrite dans la suite du texte, peuvent être interverties. Dans certains cas particuliers, les rainures de la face arrière et/ou de la face avant peuvent ne pas être nécessaires.

La figure 3 montre la formation sur les faces avant et arrière de la plaque de substrat d'une couche de passivation 126 en un matériau isolant électrique tel que la silice ou des polymères.

La formation de la couche de passivation est suivie par la réalisation d'ouvertures 128 dans cette couche, permettant de mettre à nu, au moins en partie, un certain nombre des plots de connexion 116. Une pluralité d'ouvertures peuvent être pratiquées dans la couche de passivation au-dessus d'un même plot de connexion 116 de façon à mettre à nu plusieurs parties de ce plot.

La figure 4 des dessins annexés montre la préparation d'un support de connexion destiné à recevoir la plaque de substrat avec les composants.

Une plaque de support 200, encore appelée support de connexion, est garnie sur l'une de ses faces 202, appelée face avant, d'une couche 226 en un matériau isolant électrique. A titre d'exemple, la plaque 200 et la couche 226 peuvent être en des matériaux tels que le silicium et la silice respectivement.

Une couche métallique formée sur la couche 226 de matériau isolant électrique est mise en forme pour définir des pistes conductrices 230 comprenant éventuellement des plots de connexion 231.

Dans une réalisation particulière où le matériau de la plaque de support 200 est isolant électrique tel que la silice ou l'alumine, la couche isolante 226 peut être omise. Les pistes 230, et les plots de connexion 231 sont alors formées directement sur la plaque de support.

Les pistes et les plots de connexion du support de connexion 200 sont formés selon un motif en correspondance avec une distribution des plots de connexion sur la plaque de substrat 100 décrite en référence aux figures 1 à 3.

Ainsi, les plots de connexion du support 200 viennent en regard de plots associés de la plaque de substrat 100 lorsque la plaque est reportée sur le support de connexion.

Un certain nombre de pistes, et plus précisément les plots de connexion des pistes du support de connexion sont garnis de billes de matériau fusible 232. On entend par matériau fusible un matériau tel qu'un alliage : à base d'étain de plomb et/ou d'indium, susceptible de fondre à une température relativement basse.

Eventuellement, la mise en place des billes peut être précédée par la formation sur la face avant du support de connexion d'une couche de passivation qui recouvre les pistes conductrices mais qui présente des ouvertures permettant la mise en place des billes de matériau fusible sur les pistes. Une telle couche de passivation, qui n'est pas représentée sur la figure, dans un souci de simplification, permet d'obtenir une meilleure isolation entre les pistes du support de connexion et le substrat qui y est ultérieurement reporté. Elle permet également d'éviter tout contact parasite entre des pistes voisines et de protéger les pistes contre des agents chimiques de gravure éventuellement mis en oeuvre dans la suite du procédé.

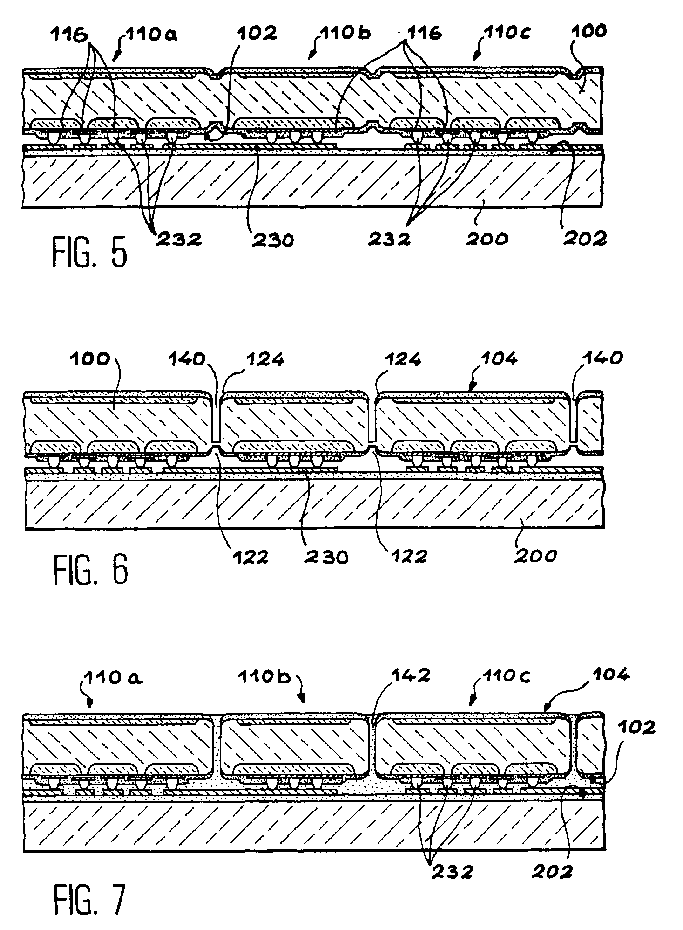

Le report de la plaque de substrat 100 sur le support de connexion est illustré à la figure 5. Lors de l'assemblage, la face avant 102 de la plaque de substrat 100 est tournée vers la face avant 202 du support de connexion de telle sorte que les billes de matériau fusible 232 viennent respectivement se positionner sur les plots de connexion 116 de la plaque de substrat, qui leur sont associés.

Il convient de préciser qu'à titre de variante, tout ou partie des billes de matériau fusible peuvent également être formées initialement sur les plots de connexion de la plaque de substrat 100, plutôt que sur ceux du support de connexion 200.

La connexion définitive entre les billes de matériau fusible et les plots de connexion est provoquée en élevant la température de l'assemblage à une température suffisante pour faire fondre le matériau des billes. Ce matériau vient alors se souder sur les plots de connexion qui sont mouillables par le matériau fusible.

Une étape suivante du procédé, illustré par la figure 6, comprend la formation de tranchées 140 dans la plaque de substrat. Ces tranchées entourent les composants 110a, 110b, 110c.

Les tranchées sont pratiquées, par exemple, par sciage à partir de la face "arrière" 104 de la plaque de substrat et coïncident avec les rainures 122, 124, préalablement formées. A titre de variante, les rainures d'évasement, et en particulier les rainures d'évasement 124 de la face arrière peuvent être formées après les tranchées.

Dans l'exemple décrit, les tranchées sont réalisées dans un premier temps par sciage et dans un deuxième temps par gravure sèche. La figure représente des tranchées non traversantes réalisées par sciage et présentant un reliquat de matière dans leur fond. Ce reliquat de matière est ensuite éliminé par la gravure sèche pour obtenir des tranchées traversantes.

Le fait d'achever les tranchées par gravure permet d'éviter un contrôle précis de la profondeur de sciage, sans risquer de venir abîmer les pistes 230 du support de connexion 200 sous-jacent.

D'autres techniques, telles que des techniques de découpage par jet d'eau ou/et par laser peuvent également être mises en oeuvre pour la formation des tranchées.

La figure 7 montre le remplissage des tranchées par un matériau diélectrique 142. Le matériau utilisé est de préférence un matériau initialement liquide qui peut être solidifié, tel que, par exemple, un matériau polymère, sol-gel ou époxy. Il peut être introduit ainsi à l'état liquide puis solidifié.

On observe que le matériau diélectrique remplit non seulement les tranchées mais s'étend également entre les faces avant 102, 202 de la plaque de substrat et du support de connexion de façon à venir enrober les billes de connexion.

Le matériau diélectrique permet de garantir à long terme la qualité de l'isolation électrique mutuelle entre les composants et l'isolation des composants par rapport au support de connexion 200.

Dans l'exemple illustré, le remplissage des tranchées est tel que le matériau diélectrique 142 affleure juste à la face arrière 104 de la plaque de substrat. Le matériau diélectrique peut aussi déborder sur la face arrière de la plaque de substrat pour réaliser une couche de passivation supplémentaire. Par ailleurs, le matériau diélectrique en excès sur la face arrière peut également être éliminé par un polissage.

Selon une mise en oeuvre particulière du procédé, les composants peuvent être testés et, éventuellement, des composants défectueux peuvent être remplacés par d'autres composants valides avant la mise en place du matériau diélectrique. De la même façon, des composants fabriqués dans d'autres plaques de substrat et selon d'autres techniques de fabrication peuvent être insérés à la place ou entre des composants de la plaque de substrat initiale. Ces composants sont également mis en place avant le matériau diélectrique.

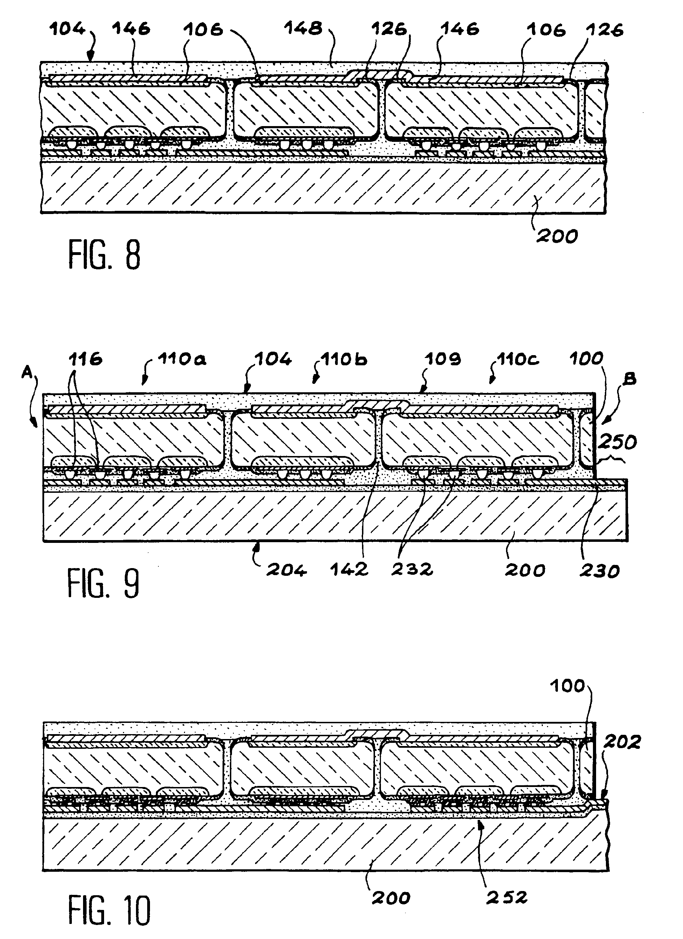

La figure 8 montre la formation sur la face arrière 104 de la plaque de substrat de pistes conductrices d'interconnexion 146 permettant de relier entre eux certains composants.

La réalisation des pistes d'interconnexion est précédée par la formation dans la couche de passivation 126 de la face arrière, d'ouvertures, permettant d'accéder, par exemple, à des régions dopées 106.

Une couche métallique est ensuite formée sur toute la face arrière 104, puis gravée selon un motif permettant de réaliser les pistes conductrices 146. Ces pistes relient entre elles des régions dopées de différents composants situés, par exemple, dans différentes portions de la plaque de substrat.

Une nouvelle couche de passivation diélectrique 148 est ensuite formée à la surface libre de la face arrière pour protéger les pistes conductrices.

Des ouvertures peuvent être pratiquées dans la nouvelle couche de passivation afin de réaliser des plots de prise de contact sur les pistes conductrices. Ces plots ne sont pas représentés sur les figures.

Après l'achèvement des étapes de traitement collectif, décrites ci-dessus, la plaque de substrat et le support de connexion peuvent être découpés pour individualiser des modules formés chacun d'un ou de plusieurs composants.

La figure 9 illustre un tel module comprenant les composants 110a, 110b et 110c.

Le découpage peut être effectué avec une scie à lame droite qui permet de couper la plaque de substrat et le support de connexion selon un même plan de coupe, repéré avec la référence A sur la partie gauche de la figure 9.

Le découpage de la plaque de substrat et du support de connexion peut aussi être effectué avec une scie à lame en marche d'escalier. Une telle lame permet de réaliser un sciage décalé de la plaque de substrat et du support de connexion. La coupe obtenue par un sciage décalé est désigné par la référence B sur la figure 9.

Le sciage décalé est mis à profit pour mettre à nu une partie en saillie 250 du support de connexion dans laquelle s'étendent des portions de piste conductrice 230 qui sont par ailleurs reliées à des composants par des billes de matériau fusible.

Des fils conducteurs de liaison peuvent être connectés aux pistes dans la partie 250 mise à nu pour relier les composants du module à d'autres équipements extérieurs (ces équipements de même que les fils conducteurs ne sont par représentés).

Cette caractéristique permet de réduire le nombre de prises de contact à réaliser sur les faces arrière 104, 204 de la plaque de substrat et/ou du support de connexion, et libère donc de la place sur ces faces pour la mise en place éventuelle de radiateurs de dissipation thermique.

La description qui précède décrit un mode de mise en oeuvre avantageux particulier dans lequel les connexions électriques entre la plaque de substrat et le support de connexion sont réalisées au moyen de billes ou de bossages de matériau fusible. Toutefois, selon d'autres possibilités de mise en oeuvre du procédé, les connexions électriques peuvent être réalisées par soudure eutectique entre les plots de connexion ou au moyen d'une colle conductrice anisotrope mise en place entre le substrat et le support. La colle conductrice anisotrope permet de ne laisser passer le courant que dans la direction substrat-support sans conduire de courant selon les directions latérales dans l'intervalle entre le substrat et le support.

Par ailleurs, les billes de matériau fusible ou les autres moyens de connexion, peuvent être logés dans une dépression 252 pratiquée dans la face avant du support de connexion 200. Dans ce cas, la plaque de substrat reportée sur le support de connexion peut reposer sur la face avant du support 202 de connexion autour de la dépression.

Cette variante est représentée sur la figure 10. La figure 10 montre également une réalisation particulière des plots de connexion de la plaque de substrat 100 pour une soudure eutectique sur les plots de la plaque de support 200.

Un dépôt métallique ou eutectique sur les plots de la plaque de substrat permet de reporter le contact électrique à la surface la plus extérieure en élargissant le plot avant d'effectuer le report sur le support.

## Revendications

1. Procédé de réalisation d'un circuit intégré comprenant une pluralité de composants électroniques (110a, 110b, 110c), le procédé comportant les étapes successives suivantes :
a) formation de la pluralité de composants (110a, 110b, 110c) dans une plaque de substrat (100) et formation de plots de connexion (116), pour lesdits composants, sur une première face (102) de la plaque de substrat,
b) formation sur un support de connexion (200) de pistes conductrices (230, 231) selon un motif en correspondance avec une distribution des plots de connexion (116) sur la plaque de substrat,
c) report de la plaque de substrat (100) sur le support de connexion (200) en connectant électriquement les plots de connexion (116) avec des pistes conductrices (230, 231) correspondantes,
d) formation d'au moins une tranchée de séparation (140) dans la plaque de substrat, entourant au moins une portion de substrat comprenant au moins un composant électronique, de façon à le séparer des autres composants de la plaque de substrat, la tranchée traversant la plaque de substrat de part en part sans atteindre le support de connexion,
e) emplissage des tranchées d'un matériau diélectrique (142), le materiau diélectrique s'étendant dans lesdites tranchées et, au moins en partie, entre ladite portion de substrat et le support de connexion.

2. Procédé selon la revendication 1, comprenant en outre, après l'étape e), un découpage de la plaque de substrat et du support de connexion pour individualiser des modules comprenant chacun au moins un composant.

3. Procédé selon la revendication 1, dans lequel l'étape a) comporte la formation d'au moins un composant de puissance parmi ladite pluralité de composants, et dans lequel lors de l'étape d) on forme au moins une tranchée entourant une portion de substrat comprenant ledit composant de puissance.

4. Procédé selon la revendication 1, dans lequel, avant l'étape c), on pratique dans la plaque de substrat des rainures (122, 124) d'évasement des tranchées, en des emplacements destinés à la formation des tranchées lors de l'étape d).

5. Procédé selon la revendication 1, dans lequel lors de l'étape e) on connecte les plots de connexion (116) et les pistes conductrices (230, 231) par un procédé de connexion choisi parmi la connexion par bossages de matériau fusible, la connexion par colle conductrice, et la connexion par soudure eutectique.

6. Procédé selon la revendication 1, dans lequel on connecte les plots de connexion (116) et les pistes conductrices (230, 231) par l'intermédiaire de bossages de matériau fusible et dans lequel on fait pénétrer le matériau diélectrique (142), introduit par les tranchées, entre la plaque de substrat (100) et le support de connexion (200), afin d'en enrober lesdits bossages.

7. Procédé selon la revendication 1, comprenant également la formation de pistes d'interconnexion (146) sur une deuxième face (104), libre, de la plaque de substrat (100), opposée à ladite première face (102), la formation des pistes d'interconnexion ayant lieu après l'étape e).

8. Procédé selon la revendication 1, dans lequel on forme ladite tranchée (140) par sciage et/ou par gravure.

9. Procédé selon la revendication 1, comprenant en outre la mise à nu d'une partie (250) du support de connexion, dans laquelle s'étend au moins une piste conductrice (230) reliée à au moins l'un des composants.

10. Procédé selon la revendication 1, comprenant en outre, avant l'étape e), le report et la connexion sur le support de connexion d'au moins un composant fabriqué dans un substrat autre que ladite plaque de substrat (100).

11. Circuit intégré comprenant une pluralité de composants (110a, 110b, 110c), formés dans des portions d'un substrat (100) séparées par des tranchées (140) traversant le substrat de part en part, un support de connexion équipé de pistes conductrices (230) connectées aux composants, recevant les portions de substrat, et un matériau diélectrique (142) s'étendant dans lesdites tranchées et, au moins en partie, entre les portions de substrat et le support de connexion.

12. Circuit intégré selon la revendication 11, comprenant des composants de puissance et des composants de commutation logique formés dans des portions de substrat différentes.

## Claims

1. Method of producing an integrated circuit comprising a plurality of electronic components (110a, 110b, 110c), the method comprising the following successive steps :
a) formation of the plurality of components (110a, 110b, 110c) in a substrate plate (100) and formation of connection points (116), for said components, on a first face (102) of the substrate plate,
b) formation on a connection support (200) of conducting tracks (230, 231) in accordance with a pattern that corresponds with a distribution of connection points (116) on the substrate plate,
c) transfer of the substrate plate (100) onto the connection support (200), electrically connecting the connection points (116) with corresponding conducting tracks (230, 231),
d) formation of at least one separation trench (140) in the substrate plate, surrounding at least one portion of substrate including at least one electronic component, in a way that separates it from the other components of the substrate plate, the trench passing right through the substrate plate without reaching the connection support,
e) filling of the trenches with a dielectric material (142), the dielectric material extending in said trenches and, at least party, between said substrate portion and the connection support.

2. Method according to Claim 1, additionally comprising, after step e), cutting the substrate plate and the connection support in order to individualize modules each comprising at least one component.

3. Method according to Claim 1 in which step a) comprises the formation of at least one power component among said plurality of components, and in which during step d) at least one trench is formed that surrounds a portion of substrate that includes said power component.

4. Method according to Claim 1, in which, before step c), grooves (122, 124) are made in the substrate plate for flaring the trenches, in locations intended for the formation of the trenches during step d).

5. Method according to Claim 1, in which, during step e), the connection points (116) and the conducting tracks (230, 231) are connected by a method of connection chosen from among connection through bosses of fusible material, connection through a conducting adhesive and connection by eutectic soldering.

6. Method according to Claim 1, in which, the connection points (116) and the conducting tracks (230, 231) are connected using bosses of fusible material and in which the dielectric material introduced through the trenches is caused to penetrate between the substrate plate (100) and the connection support (200), so as to envelope said bosses.

7. Method according to Claim 1, also comprising the formation of interconnection tracks (146) on a second free face (104), of the substrate plate (100), opposite said first face (102), the formation of the interconnection tracks taking place after step e).

8. Method according to Claim 1, in which said trench (140) is formed by sawing and/or by etching.

9. Method according to Claim 1, additionally comprising the laying bare of a part (250) of the connection support, into which at least one conducting track (230) extends, which is connected to at least one of the components.

10. Method according to Claim 1, additionally comprising, before step e), the transfer and the connection onto the connection support of at least one component produced in a substrate other than said substrate plate (100).

11. Integrated circuit comprising a plurality of components (110a, 110b, 110c), formed in portions of a substrate (100) separated by trenches (140) passing right through the substrate, a connection support equipped with conducting tracks (230) connected to the components, receiving the portions of substrate, and a dielectric material (142) extending into said trenches and, at least in part, between the portions of substrate and the connection support.

12. Integrated circuit according to Claim 11, comprising power components and logic switching components formed in different portions of substrate.

## Patentansprüche

1. Verfahren zur Herstellung einer integrierten Schaltung mit einer Vielzahl elektronischer Bauelementen (110a, 110b, 110c), die folgenden sukzessiven Schritte umfassend:
a) Bildung der Vielzahl von Bauelementen (110a, 110b, 110c) in einer Substratplatte (100) und Bildung von Verbindungskontakten (116) für die genannten Bauelementen auf einer ersten Seite (102) der Substratplatte,
b) Bildung von Leiterbahnen (230, 231) auf einem Verbindungsträger (200) gemäß einem mit der Verteilung der Verbindungskontakte (116) auf der Substratplatte übereinstimmenden Muster,
c) Übertragung der Substratplatte (100) auf den Verbindungsträger (200), wobei die Verbindungskontakte (116) mit den entsprechenden Leiterbahnen (230, 231) elektrisch verbunden werden,
d) Bildung wenigstens eines Trenngrabens (140) in der Substratplatte, der wenigstens einen wenigstens ein elektronische Bauelement enthaltenden Teil des Substrats umgibt, um es von den anderen Bauelementen der Substratplatte zu trennen, wobei der Graben die Substratplatte durchdringt, ohne an den Verbindungsträger heranzureichen,
e) Füllen der Gräben mit einem dielektrischen Material (142), wobei sich das dielektrische Material in den genannten Gräben und wenigstens teilweise zwischen dem genannten Substratteil und dem Verbindungsträger erstreckt.

2. Verfahren nach Anspruch 1 das außerdem - nach Schritt e) - ein Zuschneiden der Substratplatte und des Verbindungsträgers umfasst, um Module zu vereinzeln, von denen jeder wenigstens ein Bauelement umfasst.

3. Verfahren nach Anspruch 1, bei dem der Schritt a) die Bildung wenigstens eines Leistungsbauelements unter der genannten Vielzahl von Bauelementen umfasst, und bei dem man in Schritt d) wenigstens einen Graben ausbildet, der einen das genannte Leistungsbauelement enthaltenden Teil des Substrat umgibt.

4. Verfahren nach Anspruch 1, bei dem man - vor dem Schritt c) - in der Substratplatte an den zur Bildung der Gräben in Schritt d) bestimmten Stellen Rillen (122, 124) zur Ausweitung der Gräben realisiert.

5. Verfahren nach Anspruch 1, bei dem man in Schritt e) die Verbindungskontakte (116) und die Leiterbahnen (230, 231) durch ein Verbindungsverfahren verbindet, das ausgewählt wird unter den Verbindungen des Typs Bumps bzw. Höcker aus schmelzbarem Material, Verbindungen des Typs leitende Kleber und Verbindungen des Typs eutektisches Lösten.

6. Verfahren nach Anspruch 1, bei dem man die Verbindungskontakte (116) und die Leiterbahnen (230, 231) durch Höcker aus schmelzbarem Material verbindet, und bei dem man das durch die Gräben eingeführte dielektrische Material (142) eindringen lässt zwischen die Substratplatte (100) und den Verbindungsträger (200), so dass es die genannten Höcker umgibt.

7. Verfahren nach Anspruch 1 mit der Bildung von Leiterbahnen (146) auch auf einer der ersten Seite (102) entgegengesetzten zweiten Seite (104) der Substratplatte (100), wobei die Bildung der Leiterbahnen nach dem Schritt e) erfolgt.

8. Verfahren nach Anspruch 1, bei dem man den genannten Graben (140) durch Sägen und/oder Ätzen realisiert,

9. Verfahren nach Anspruch 1 mit außerdem der Freilegung eines Teils (250) des Verbindungsträgers, in dem sich wenigstens eine mit wenigstens einem der Bauelemente verbundene Leiterbahn (230) erstreckt.

10. Verfahren nach Anspruch 1 mit außerdem, vor dem Schritt e), der Übertragung - und der Verbindung - wenigstens eines in einem anderen Substrat als der genannten Substratplatte (100) hergestellten Bauelements auf den - mit dem - Verbindungsträger.

11. Integrierte Schaltung mit einer Vielzahl Bauelemente (110a, 110b, 110c), ausgebildet in Teilen eines Substrats (100), getrennt durch das Substrat durchdringende Gräben (140), wobei ein Verbindungsträger, versehen mit Leiterbahnen (230), die mit den Bauelementen verbunden sind, die genannten Substratteile aufnimmt, und ein dielektrisches Material (142) sich in den Gräben und wenigstens teilweise zwischen den genannten Substratteilen und dem Verbindungsträger erstreckt.

12. Integrierte Schaltung nach Anspruch 11 mit Leistungsbauelementen und Logikschalteiementen, ausgebildet in verschiedenen Substratteilen.
